# EUROPEAN PATENT APPLICATION

(11) **EP 4 458 921 A1**
(43) Date of publication of application: **06.11.2024**
(21) Application number: 22915626.0
(22) Date of filing: 01.12.2022
(51) Int. Cl.: C09J 133/14, C09J 175/04, C09J 7/38, H01L 21/02, H01L 21/683

(54) **DOUBLE-SIDED ADHESIVE**

(30) Priority: 28.12.2021 JP 2021214451
(71) Applicant: Mitsui Chemicals ICT Materia, Inc., Tokyo 104-0028 (JP)
(72) Inventor: UNEZAKI, Takashi, Sodegaura-shi, Chiba 299-0265 (JP); HARUTA, Kaichiro, Sodegaura-shi, Chiba 299-0265 (JP); TANIMOTO, Shuho, Sodegaura-shi, Chiba 299-0265 (JP); SUZUKI, Takashi, Sodegaura-shi, Chiba 299-0265 (JP); KINOSHITA, JIN, Nagoya-shi, Aichi 457-0801 (JP)
(74) Representative: J A Kemp LLP
(86) International application number: PCT/JP2022/044440
(87) International publication number: WO 2023/127395

(57) **Abstract**

The present invention addresses the problem of providing a double-sided adhesive for use in wafer support systems, wherein a wafer can be stably separated from a laminate by a relatively simple process such as mechanical peeling. The problem can be resolved by a double-sided adhesive for use in wafer support systems, the double-sided adhesive having one adhesive surface A and another adhesive surface B, wherein the ratio P₂/P₁ of 10° peel strength P₂ between a Si mirror wafer and the adhesive surface B to 10° peel strength P₁ between a silicon back surface-grinding support substrate made from borosilicate glass and the adhesive surface A is at least 1.1 as measured while keeping the angle between the separated layers at 10°.

## Description

### TECHNICAL FIELD

The present invention relates to a double-sided adhesive for use in a wafer treatment method (a wafer support system) in which a wafer is processed or the like in a state where the wafer is temporarily fixed to a support, and more specifically, relates to a double-sided adhesive capable of stably separating the support and the wafer by a relatively simple method such as mechanical peeling while improving handling properties of the wafer and being usable in a wide variety of treatment processes by temporarily fixing the support and the wafer.

### BACKGROUND ART

In a semiconductor production process, temporary fixing is often required or preferable in a wafer treatment due to thinness of a wafer and ease of breaking of a wafer. For example, for high integration of a semiconductor device, thin grinding of a wafer on which a functional layer for a semiconductor device is formed is widely performed. However, when grinding is performed to an extreme thinness, it is not possible to support the wafer only with a tape, and thus, it has been proposed to perform a treatment after thin grinding by temporarily fixing the wafer to a hard carrier (support) via an adhesive. Such a semiconductor production process using a support is referred to as a wafer support system.

As a method for peeling the support after the treatment, a method using gas generation from the adhesive (for example, refer to Patent Literature 1), a peeling method using a laser, a peeling method in which a resin of the adhesive is melted to slide off the carrier, a method in which the carrier is lifted from one end and peeled off (mechanical peeling), and the like have been proposed.

The mechanical peeling method is excellent in cost advantage because the apparatus is relatively simple. However, since in principle, in the mechanical peeling method, a peel force is applied to at least an interface between the wafer and the adhesive and an interface between the adhesive and the support, it is not necessarily easy to perform stable peeling at a desired interface. When peeling occurs at an unintended interface (for example, the interface between the wafer and the adhesive), problems such as damage to the support or an electronic component may occur when peeling the support.

On the other hand, it is also possible to increase the adhesive force at the unintended interface so as not to cause peeling at the unintended interface when performing the mechanical peeling. However, when the adhesive force is excessively increased, for example, it becomes difficult to peel off the adhesive from the wafer.

### CITATION LIST

### PATENT LITERATURE

PATENT LITERATURE 1: WO 2014/024861 A1 pamphlet

### SUMMARY OF INVENTION

### TECHNICAL PROBLEM

In consideration of the technical background described above, an object of the present invention is to provide a double-sided adhesive for use in a wafer support system, in which a wafer can be stably separated from a laminate by a relatively simple process such as mechanical peeling.

### SOLUTION TO PROBLEM

As a result of intensive studies, the present inventors have found that when a ratio of peel strength between an adhesive and a specific Si-based wafer to peel strength between a specific glass substrate and an adhesive, which is measured in a specific condition, satisfies a specific condition, the wafer can be stably separated from a laminate by a relatively simple process such as mechanical peeling, and have completed the present invention.

That is, the present invention relates to,
[1]
   a double-sided adhesive for use in a wafer support system, comprising: one adhesive surface A; and another adhesive surface B, in which
   a ratio P₂/P₁ of 10° peel strength P₂ between a Si mirror wafer and the adhesive surface B to 10° peel strength P₁ between a silicon back surface-grinding support substrate made from borosilicate glass and the adhesive surface A, which is measured while keeping an angle between peeled layers at 10° respectively, is 1.1 or more.

Hereinafter, any of [2] to [6] is a preferable aspect or embodiment of the present invention.
[2] The double-sided adhesive according to [1], in which the 10° peel strength P₁ is 12 N/25 mm or less.
[3] The double-sided adhesive according to [1] or [2], comprising: an adhesive layer A1 having the adhesive surface A; and an adhesive layer B1 having the adhesive surface B, in which the adhesive layer A1 and the adhesive layer B1 have different compositions.
[4] The double-sided adhesive according to any one of [1] to [3], in which at least one of the adhesive layer A1 and the adhesive layer B1 contains a curable adhesive component.
[5] The double-sided adhesive according to any one of [1] to [4], comprising a base film between the adhesive layer A1 and the adhesive layer B1.
[6] The double-sided adhesive according to any one of [1] to [5], in which at least one of the adhesive layer A1 and the adhesive layer B1 contains a release agent.

### ADVANTAGEOUS EFFECTS OF INVENTION

According to the double-sided adhesive of the present invention, since the handling property of the wafer that is thin or easily broken is improved, it is possible to stably process the wafer in a wide variety of treatment processes, and since peeling or the like at an unintended interface is effectively suppressed, it is possible to stably separate and take out the processed wafer from by a relatively simple and low-cost process such as mechanical peeling. Therefore, it is possible to perform a large number and/or a wide variety of steps on the wafer with high productivity and yield without damaging an electronic component such as a functional layer formed on the wafer. As a result, the present invention greatly contributes to improvement in the productivity of the electronic component of an electronic device or the like.

### BRIEF DESCRIPTION OF DRAWINGS

FIG. 1 is a schematic view illustrating mechanical peeling in a laminate formed using a double-sided adhesive of the present invention.
FIG. 2 is a schematic view illustrating separation of a support from a laminate, in which (a) illustrates a preferable separation form, and (b) and (c) illustrate an unpreferable separation form.

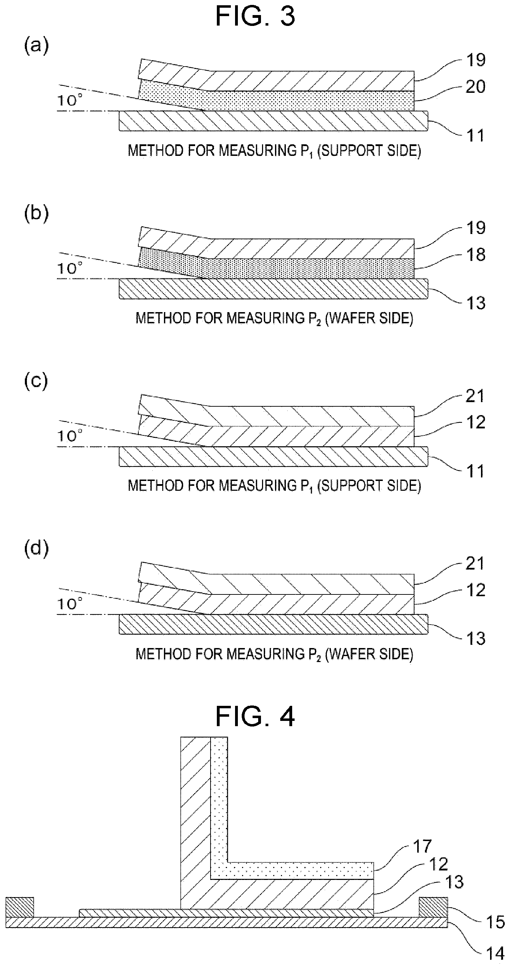

FIG. 3 is a schematic view illustrating a method for measuring 10° peel strength specified in the present invention, in which (a) illustrates a case where measurement is performed using a sample for measuring 10° peel strength P₁ in which an adhesive layer A1 on a side in contact with a support is laminated on a base film, (b) illustrates a case where measurement is performed using a sample for measuring 10° peel strength P₂ in which an adhesive layer B1 on a side in contact with a wafer is laminated on a base film, (c) illustrates a case where measurement is performed using a sample for measuring 10° peel strength P₁ in which a polyimide film is laminated on a double-sided adhesive having no base film, and (d) illustrates a case where measurement is performed using a sample for measuring 10° peel strength P₂ in which a polyimide film is laminated on a double-sided adhesive having no base film.
FIG. 4 is a schematic view illustrating a method for evaluating removability from a wafer in the double-sided adhesive of the present invention.
FIG. 5 is a schematic view illustrating a laminate formed using a double-sided adhesive having a base film that is an embodiment of the present invention.
FIG. 6 is a schematic view illustrating a laminate formed using the double-sided adhesive of the present invention.

### DESCRIPTION OF EMBODIMENTS

The present invention is
a double-sided adhesive for use in a wafer support system, comprising one adhesive surface A and another adhesive surface B,
wherein a ratio P₂/P₁ of 10° peel strength P₂ between a Si mirror wafer and the adhesive surface B to 10° peel strength P₁ between a silicon back surface-grinding support substrate made from borosilicate glass and the adhesive surface A, which is measured while keeping an angle between peeled layers at 10° respectively, is 1.1 or more.

That is, in the double-sided adhesive of the present invention, the 10° peel strength between a specific glass substrate and the adhesive surface A is different from the 10° peel strength between a specific Si-based wafer and the adhesive surface B.

### Double-Sided Adhesive

Since the double-sided adhesive of the present invention is used for temporarily fixing a wafer to a support, it is preferable that the double-sided adhesive can be easily peeled off from the support and the wafer. Therefore, the double-sided adhesive of the present invention has a sufficient adhesive force to fix the wafer to the support, but has a sufficiently low adhesive force to be peeled off.

Specifically, when peeling is performed from a laminate by a mechanical peeling method, P₂/P₁ which is a ratio of peel strength measured while keeping the angle between the peeled layers at 10° respectively (in this specification, referred to as the "10° peel strength") is preferably 1.1 or more.

Here, P₁ is the 10° peel strength between the specific glass substrate and the adhesive surface A, more specifically between the silicon back surface-grinding support substrate made from the borosilicate glass and the adhesive surface A. P₂ is the 10° peel strength between the specific Si-based wafer and the adhesive surface B, more specifically between the Si mirror wafer and the adhesive surface B.

The double-sided adhesive of the present invention may be a single layer or a laminate of a plurality of layers.

In the case of the laminate of the plurality of layers, the double-sided adhesive of the present invention includes an adhesive layer A1 having the adhesive surface A and an adhesive layer B1 having the adhesive surface B, and the adhesive layer A1 and the adhesive layer B1 may have different compositions. In this case, one adhesive surface A can be configured to have predetermined peel strength with the specific glass substrate, and the other adhesive surface B can be configured to have predetermined peel strength with the specific Si-based wafer. In this case, it is preferable that the adhesive layer A1 and the adhesive layer B1 have different compositions. In this case, the adhesive layer A1 and the adhesive layer B1 may have a layered configuration in a general sense, in which the composition discontinuously changes at the interface, but may have a so-called gradient composition, in which the composition continuously changes.

An adhesive component used in the double-sided adhesive of the present invention includes, for example, components containing a rubber-based adhesive component, an acrylic adhesive component, an epoxy-based adhesive component, a urethane-based adhesive component, an allyl-based adhesive component, a silicone-based adhesive component, a fluorine-based adhesive component, or a polyimide-based adhesive component. Among them, the acrylic adhesive component or the silicone-based adhesive component is preferable because such a component has heat resistance and is easy to adjust a pressure-sensitive force and an adhesive force.

The adhesive component may be a curable adhesive component or a non-curable adhesive component. Since by curing an adhesive component before a heat treatment, voids are less likely to be generated in the heat treatment during a production step and adhesion acceleration due to a high temperature during the heat treatment can be suppressed to perform peeling easily without an adhesive residue, the curable adhesive component is preferable.

Examples of the curable adhesive component include a photocurable adhesive component that is crosslinked and cured by light irradiation and a thermosetting adhesive component that is crosslinked and cured by heating.

The photocurable adhesive component and the thermosetting adhesive component include, for example, a photocurable adhesive component and a thermosetting adhesive component containing a monomer, an oligomer, or a polymer such as acryl, epoxy, urethane acrylate, epoxy acrylate, silicone acrylate, or polyester acrylate as a curable component and containing a photopolymerization initiator or a thermal polymerization initiator.

Among them, the polymer of the acrylic adhesive component can be obtained, for example, by synthesizing in advance a (meth)acrylic polymer having a functional group in the molecule (hereinafter, referred to as a functional group-containing (meth)acrylic polymer) to react with a compound having a functional group that reacts with the functional group and a radically polymerizable unsaturated bond in the molecule (hereinafter, referred to as a functional group-containing unsaturated compound).

The functional group-containing (meth)acrylic polymer is obtained by copolymerizing alkyl acrylate and/or alkyl methacrylate having an alkyl group having usually 2 to 18 carbon atoms as a main monomer, a functional group-containing monomer, and as necessary, other modifying monomers copolymerizable with these monomers by a conventional method. The weight average molecular weight of the functional group-containing (meth)acrylic polymer is usually approximately 200000 to 2000000.

The functional group-containing monomer includes, for example, a carboxyl group-containing monomer such as an acrylic acid and a methacrylic acid, a hydroxyl group-containing monomer such as hydroxyethyl acrylate and hydroxyethyl methacrylate, an epoxy group-containing monomer such as glycidyl acrylate and glycidyl methacrylate, an isocyanate group-containing monomer such as isocyanate ethyl acrylate and isocyanate ethyl methacrylate, and an amino group-containing monomer such as aminoethyl acrylate and aminoethyl methacrylate.

The other copolymerizable modifying monomers include, for example, various monomers used for a general (meth)acrylic polymer such as vinyl acetate, acrylonitrile, and styrene.

As the functional group-containing unsaturated compound that reacts with the functional group-containing (meth)acrylic polymer, the same functional group-containing monomer as described above can be used in accordance with the functional group of the functional group-containing (meth)acrylic polymer. For example, when the functional group of the functional group-containing (meth)acrylic polymer is a carboxyl group, an epoxy group-containing monomer or an isocyanate group-containing monomer is used. When the functional group is a hydroxyl group, an isocyanate group-containing monomer is used. When the same functional group is an epoxy group, a carboxyl group-containing monomer or an amide group-containing monomer such as acrylamide is used. When the functional group is an amino group, an epoxy group-containing monomer is used.

The photopolymerization initiator includes, for example, those that are activated by irradiation with light having a wavelength of 250 to 800 nm. Such a photopolymerization initiator includes, for example, photoradical polymerization initiators such as an acetophenone derivative compound such as methoxyacetophenone, a benzoin ether-based compound such as benzoin propyl ether and benzoin isobutyl ether, a ketal derivative compound such as benzyl dimethyl ketal and acetophenone diethyl ketal, a phosphine oxide derivative compound, a bis(η5-cyclopentadienyl) titanocene derivative compound, benzophenone, Michler's ketone, chlorothioxanthone, dodecyl thioxanthone, dimethyl thioxanthone, diethyl thioxanthone, α-hydroxycyclohexyl phenyl ketone, and 2-hydroxymethyl phenyl propane. These photopolymerization initiators may be used alone, or two or more types thereof may be used together.

Examples of the thermal polymerization initiator include those that are decomposed by heat to generate active radicals for initiating polymerization curing. Specifically, the thermal polymerization initiator includes, for example, t-butyl peroxy-2-ethyl hexanoate, bis(4-methyl benzoyl) peroxide, benzoyl peroxide, 1,1-bis(t-hexyl peroxy)cyclohexane, 1,1-bis(t-butyl peroxy)cyclohexane, 2,2-bis(4,4-bis-(t-butyl peroxy)cyclohexyl) propane, t-hexyl peroxyisopropyl monocarboxylate, t-butyl peroxyacetate, 2,2-bis-(t-butyl peroxy)butane, n-butyl 4,4-bis-(t-butyl peroxy)pentanoate, bis-t-hexyl peroxide, dicumyl peroxide, 2,5-dimethyl-2,5-bis(t-butyl peroxy)hexane, bis(2-t-butyl peroxypropyl) benzene, t-butyl cumyl peroxide, di-t-butyl peroxide 2,5-dimethyl-2,5-bis(t-butyl peroxy)hexyne, and diisopropyl benzene hydroperoxide.

Among these thermal polymerization initiators, a commercially available one is not particularly limited, and for example, PERBUTYL O, NYPER BMT, NYPER BW, PERHEXA HC, PERHEXA C, PERTETRA A, PERHEXYL I, PERBUTYL A, PERHEXA 22, PERHEXA V, PERHEXYL D, PERCUMYL D, PERHEXA 25B, PERBUTYL P, PERBUTYL C, PERHEXYNE 25B, and PERCUMYL P (all manufactured by NOF CORPORATION), Perkadox 12XL25 (manufactured by KAYAKU NOURYON CORPORATION), and the like are suitable. These thermal polymerization initiators may be used alone, or two or more types thereof may be used together.

In general, the oligomer or the monomer as the curable component has 10000 or less of molecular weight, and has 1 to 40 of radically polymerizable unsaturated bonds in the molecule. The number of radically polymerizable unsaturated bonds is preferably 2 or more from the viewpoint of three-dimensional reticulation.

The oligomer or the monomer as the curable component includes, for example, trimethylol propane triacrylate, tetramethylol methane tetraacrylate, pentaerythritol triacrylate, pentaerythritol tetraacrylate, dipentaerythritol monohydroxypentaacrylate, dipentaerythritol hexaacrylate, or the equivalent methacrylates to the above. In addition, other examples include 1,4-butylene glycol diacrylate, 1,6-hexanediol diacrylate, polyethylene glycol diacrylate, commercially available oligoester acrylate, urethane acrylate, or the equivalent methacrylates to the above. These polyfunctional oligomers or monomers may be used alone, or two or more types thereof may be used together.

The double-sided adhesive of the present invention may contain, as desired, known additives such as various thermal crosslinking agents such as an acrylic polymer having no unsaturated double bond, an isocyanate compound, a melamine compound, and an epoxy compound, a release agent, a plasticizer, a resin, a surfactant, a wax, and a fine particle filler.

In the double-sided adhesive of the present invention, it is preferable to use a release agent from the viewpoint of adjusting the peel strength between the specific glass substrate and the adhesive surface A and/or between the specific Si-based wafer and the adhesive surface B.

The release agent is not particularly limited as long as a release effect is generally exhibited. For example, the release agent includes a hydrocarbon-based compound, a silicone-based compound, and a fluorine-based compound. The release agent also includes a polyethylene-based wax, a carnauba wax, a montanic acid, and a stearic acid, which are known as a release agent for a plastic material. Among them, the silicone-based compound and the fluorine-based compound are preferable, and a silicone-based compound and a fluorine-based compound having a functional group crosslinkable with a curable adhesive agent are more preferable.

In particular, since the silicone compound is excellent in heat resistance, the silicone compound prevents the scorching and the like of the adhesive even after a treatment involving heating at 200°C or higher, and when performing peeling, the silicone compound bleeds out to the interface of an adherend to facilitate the peeling. Since the silicone compound has a functional group crosslinkable with the curable adhesive agent, the silicone compound chemically reacts with the curable adhesive agent by light irradiation or heating and is incorporated into the curable adhesive agent, so that the silicone compound does not adhere to the adherend and cause contamination. In addition, by blending the silicone compound, an effect of preventing the adhesive residue onto a semiconductor chip is also exhibited.

In addition, the other release agent include a plasticizer. The plasticizer is not particularly limited as long as the adhesive force of the adhesive to the adherend is generally reduced. Examples thereof include a plasticizer such as trimellitate, pyromellitate, phthalate, and adipate.

The additive amount of the release agent is not particularly limited, but the additive amount is appropriately determined so as to obtain a release effect. On the other hand, the additive amount is controlled such that the additive amount is not excessive so as not to significantly impair the adhesion function of the double-sided adhesive of the present invention. For example, with respect to 100 parts by mass of the total amount of the double-sided adhesive, it is desirable to adjust the additive amount to usually 0.1 to 5 parts by mass, preferably 0.1 to 3 parts by mass, and more preferably approximately 0.1 to 1 parts by mass, as a guide, in accordance with a peel force.

In addition, in the case of adding the plasticizer, it is desirable to adjust the additive amount to usually 5 to 50 parts by mass, preferably 10 to 50 parts by mass, and more preferably 20 to 40 parts by mass, as a guide, in accordance with the peel force.

In this aspect, these release agents can be used alone or in combination.

The thickness of the double-sided adhesive of the present invention is not particularly limited, but a preferable lower limit is 5 µm and a preferable upper limit is 250 µm, and a more preferable lower limit of the thickness of the double-sided adhesive is 10 µm and a more preferable upper limit of the thickness of the double-sided adhesive is 200 µm. When the thickness of the double-sided adhesive is within such a range, the irregularities of the wafer are absorbed, and thus, the wafer can be temporarily fixed to the support with sufficient strength, and the peel force is easily adjusted to a suitable range even when the double-sided adhesive is peeled off.

In one embodiment, the double-sided adhesive of the present invention is preferably a so-called double-sided adhesive tape having a base film between the adhesive layer A1 and the adhesive layer B1. In this aspect, the adhesive layer A1 and the adhesive layer B1 can be designed from the viewpoint of optimizing the peel strength between the adhesive surface A or the adhesive surface B and the specific glass substrate or the specific Si-based wafer. The base film can be designed from the viewpoint of the mechanical strength, the handling properties, and the like of the entire double-sided adhesive and the entire laminate of the present invention, which is particularly advantageous from the viewpoint of optimizing the performance of the double-sided adhesive.

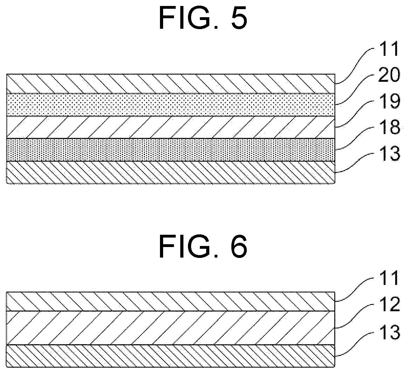

FIG. 5 illustrates an example of the laminate using the double-sided adhesive having the base film between the adhesive layer A1 and the adhesive layer B1. In the drawing, a reference numeral 11 represents the support, a reference numeral 20 represents the adhesive layer A1, a reference numeral 19 represents the base film, a reference numeral 18 represents the adhesive layer B1, and a reference numeral 13 represents the wafer.

The material of the base film is not particularly limited, but a plastic film is preferably used. The plastic film includes, for example, a film or a sheet such as acryl, olefin, polycarbonate, vinyl chloride, ABS, polyethylene terephthalate (PET), polyethylene naphthalate (PEN), nylon, urethane, polyether ether ketone (PEEK), a liquid crystal polymer (LCP), and polyimide, a sheet having a mesh structure, and a perforated sheet. From the viewpoint of handling and the like, PET, PEN, or a polyimide film is preferable.

### Support

The support preferably has sufficient strength and rigidity and is excellent in heat resistance and chemical resistance. By using such a support, it is possible to stably handle the wafer even when the wafer is thinly ground, and it is possible to provide the wafer to a large number of and/or a wide variety of processes without causing curvature or the like. For example, a wafer on which an electronic circuit is formed can be provided for various processes required for producing an electronic device having a structure in which a semiconductor chip such as TSV connection is stacked.

Examples of the material preferably used for the support include silicon, sapphire, quartz, a metal (for example, aluminum, copper, and steel), and various glasses and ceramics. The support may be composed of a single material, and may be composed of a plurality of materials, or may include other materials deposited on the base. The support may have, for example, a deposited layer of silicon nitride or the like on a silicon wafer. The support may be subjected to a surface treatment such as providing a silicone layer.

Depending on the temperature of the process to which the laminate is provided, the support may be composed of plastic. For example, a sheet consisting of plastic such as polyimide, acryl, polyolefin, polycarbonate, vinyl chloride, ABS, polyethylene terephthalate (PET), nylon, or urethane can be preferably used as the support. Since polyimide has a certain degree of heat resistance, the polyimide can be used.

As the support in the case of using the double-sided adhesive of the present invention, the specific glass substrate is preferable. In particular, in the measurement of the 10° peel strength P₁ of the double-sided adhesive of the present invention, a silicon back surface-grinding support substrate made of borosilicate glass is used as the support. More specifically, a silicon back surface-grinding support substrate made of borosilicate heat-resistant glass is preferable.

In order to obtain uniformity in the thickness of the wafer after grinding or the like, the thickness of the support is desirably uniform. For example, in order to decrease the thickness of the silicon wafer to 50 µm or less and make the uniformity thereof ±10% or less, a variation in the thickness of the support is to be suppressed to ±2 µm or less.

The thickness of the support is not particularly limited, but is preferably 300 µm or more, and particularly preferably 500 µm or more, from the viewpoint of effectively preventing the curvature of the wafer. The thickness is preferably 1500 µm or less, and particularly preferably 1000 µm or less, from the viewpoint of suppressing the total weight during handling, reducing a stress required for mechanical peeling, or the like.

### Wafer

The wafer temporarily fixed to the support and processed using the double-sided adhesive of the present invention is not particularly limited, and any wafer generally used in a semiconductor production process or the like can be used. Among them, a wafer, which requires careful handling in the treatment from reasons such as thinness and ease to break, and thus, requires temporary fixing, is preferably used. Here, regarding the thinness and the ease to break of the wafer, for example, a case is assumed in which the thickness is temporarily reduced in the middle of the treatment and handling is hindered, and the double-sided adhesive of the present invention is used for temporarily fixing such a wafer to the support. Examples of the case where the thickness of the wafer is temporarily reduced include a case where processing is performed with a thin wafer as a starting point, a case where a thick wafer is thinned in the middle of the process, and a case where processing is further performed with a thinned wafer. The thickness of the temporarily thinned wafer is usually 1 to 200 µm.

For example, in a case where a semiconductor wafer on which the processing of a functional layer is completed is temporarily fixed to the support such that the functional layer is on the support side, the opposite side surface (the back surface) of the functional layer is supplied to steps of thinly grounding, ion implantation, annealing, and electrode formation, and the semiconductor wafer is separated from the support, the semiconductor wafer in the steps corresponds to the wafer.

As described above, the wafer temporarily fixed using the double-sided adhesive of the present invention includes a wafer of which the state is changed in the process.

The wafer temporarily fixed using the double-sided adhesive of the present invention as described above is not particularly limited, and more specific examples thereof include, in the semiconductor wafer, a silicon wafer, a compound semiconductor wafer such as SiC, AlSb, AlAs, AlN, AlP, BN, BP, BAs, GaSb, GaAs, GaN, GaP, InSb, InAs, InN, or InP, a crystal wafer, sapphire, glass, and a mold wafer.

The silicon wafer or the compound semiconductor wafer may be doped.

As the wafer in the case of using the double-sided adhesive of the present invention, a specific Si-based wafer is preferable. In particular, in the measurement of the 10° peel strength P₂ of the double-sided adhesive of the present invention, a Si mirror wafer is used as the wafer.

An electrical/electronic functional layer may be formed on or in the wafer. Examples of a suitable functional layer include an electronic circuit, a capacitor, a transistor, a resistor, an electrode, an optical element, and MEMS, but a microdevice other than these may be used.

The surface of these functional layers may have a structure, typically an electrode, formed from one or more of the following materials. The materials of the functional layer include silicon, polysilicon, silicon dioxide, silicon (oxy)nitride, a metal (for example, copper, aluminum, gold, tungsten, and tantalum), a low-k dielectric, a polymer dielectric, and various metal nitrides and metal silicides. The surface of the wafer on which the functional layer is formed (the functional layer surface) may have a raised structure such as the bulge of solder, a metal post, and a pillar.

In addition, the wafer surface may be covered with an oxide film or a nitride film for forming a functional layer or protecting the functional layer. In addition, the wafer surface may be covered with a passivation film for wafer protection. The 10° peel strength P₂ between the Si mirror wafer and the adhesive surface B may be changed due to the presence of such a functional layer or film on the wafer surface, but does not deviate from the range of the suitable 10° peel strength P₂ described later, and does not significantly affect the peel strength ratio P₂/P₁.

### Laminate

According to the double-sided adhesive of the present invention, for example, by fixing the support to one adhesive surface A and fixing the wafer to another adhesive surface B, the laminate consisting of the support, the double-sided adhesive, and the wafer can be obtained. The laminate has sufficient strength and rigidity, and thus, the wafer can be provided to various semiconductor production processes while preventing the curvature and the damage.

As a method for forming the laminate, the support, the double-sided adhesive, and the wafer can be laminated in this order. The order of lamination is not particularly limited, and these layers may be laminated at a time or may be sequentially laminated.

When the adhesive is supplied as a liquid curable adhesive or the like, the liquid curable adhesive or the like can be applied onto any one or both of the wafer and the support by spin coating or the like to form the adhesive or a precursor of the adhesive, and then, to produce the laminate.

When the adhesive or the precursor of the adhesive is supplied as a solid film, since adhesive strength to the support is usually set to be lower than that on the wafer side, from the viewpoint of preventing peeling during handling, it is preferable to first bond the film onto the wafer and then further laminate the support.

In addition, when the film is attached under normal pressure and only the formation of the laminate is performed while the pressure is reduced, from the viewpoint of improving the absorbability of the irregularities of the wafer, it is preferable to first attach the film onto the support and then further bond the film onto the wafer.

When the adhesive or the precursor of the adhesive contains the curable adhesive component, the adhesive may be used by crosslinking and curing the curable adhesive component in the formation of the laminate with light irradiation or heating.

The chemical resistance of the curable adhesive component crosslinked and cured by light irradiation or heating is dramatically improved. Therefore, even when, for example, the back surface of the wafer is subjected to a chemical treatment in a wafer treatment step, it is possible to suppress the adhesive from being eluted in a chemical. In addition, since the elastic modulus of the crosslinked and cured curable adhesive component increases, the adhesion acceleration hardly occurs even at a high temperature, and peeling is relatively easily performed.

As described above, in this embodiment, although the wafer is subjected to the heat treatment, the machine processing, and/or a wet treatment in the wafer treatment step, a sufficient adhesive force can be maintained when treating the wafer, and the wafer can be peeled off from the adhesive without being damaged or causing the adhesive residue in a step of peeling off the wafer from the laminate after the completion of the wafer treatment step.

For example, when an adhesive component containing a polymer having an unsaturated double bond such as a vinyl group on a side chain and a photopolymerization initiator that is activated at a wavelength of 250 to 800 nm is used as a photocurable adhesive component that is crosslinked and cured by the light irradiation, such a photocurable adhesive component is preferably irradiated at an illuminance of 5 mW or more, more preferably at an illuminance of 10 mW or more, even more preferably at an illuminance of 20 mW or more, and particularly preferably at an illuminance of 50 mW or more. Further, the irradiation is performed at an integrated illuminance of preferably 300 mJ or more, more preferably 500 mJ or more and 10000 mJ or less, even more preferably 500 mJ or more and 7500 mJ or less, and particularly preferably 1000 mJ or more and 5000 mJ or less.

In addition, for example, in the case of using an adhesive containing a polymer having an unsaturated double bond such as a vinyl group on a side chain and a thermal polymerization initiator that is activated by heating at approximately 50 to 200°C as a thermosetting adhesive component in which an adhesive or a precursor of the adhesive is crosslinked and cured by the heating, the thermosetting adhesive component can be crosslinked and cured by heating at a temperature of approximately 50 to 200°C for 10 to 60 minutes.

When the precursor of the adhesive is cured to form the adhesive as described above, the precursor may be laminated with the support or the wafer after being cured, may be cured after being laminated, or may be finally cured after being laminated in a semi-cured state.

### Treatment of Wafer

The laminate formed using the double-sided adhesive of the present invention can be provided to at least one wafer treatment selected from a heat treatment (including a treatment involving heat generation, the same applies hereinafter), machine processing, a wet treatment, and laser processing. In addition, the laminate formed using the double-sided adhesive of the present invention can also be subjected to TSV processing or processing necessary for forming a structure in which a semiconductor chip subjected to TSV processing is laminated.

The heat treatment includes, for example, sputtering, vapor deposition, etching, chemical vapor deposition (CVD), physical vapor deposition (PVD), resist coating/patterning, heating laminating of a resin composition film, thermal curing of a resin composition, heating drying of a resin composition, baking of a resin composition, reflow, resin sealing, a plasma treatment, chip bonding, wire bonding, flip chip bonding, and surface activated direct bonding, but are not limited thereto.

The machine processing is typically polishing, grinding, drilling, and dicing of the wafer, but is not limited thereto, and includes singulation and the like.

In the case of grinding or polishing a wafer having an electrode formed on the surface, the surface (the back surface) on which the electrode is not formed is ground or polished. The thickness of the wafer after grinding and polishing the back surface is different in accordance with electronic equipment in which the obtained electronic device is used, but is usually set to 1 µm or more and 200 µm or less, preferably 5 µm or more and 100 µm or less, and more preferably 5 µm or more and 50 µm or less. As a result, the obtained electronic device is thinned, and the downsizing of the electronic equipment using such an electronic device is attained.

In this embodiment, when the wafer is ground and polished, the wafer can be ground or the like with more excellent processing accuracy by being laminated with a rigid support via the double-sided adhesive, and after the grinding or the like, the wafer can be provided to a further processing step or easily separated from the support and the double-sided adhesive without damaging the wafer.

The wet treatment is a coating treatment such as spin coating, inkjet, or screen printing, a polishing treatment such as CMP, or a treatment using an acid, an alkali, or an organic solvent. For example, the wet treatment includes, but are not limited to, a plating treatment such as electrolytic plating or electroless plating, a wet etching treatment with a hydrofluoric acid, an aqueous solution of a tetramethyl ammonium hydroxide (TMAH), or the like, a resist peeling process with N-methyl-2-pyrrolidone, monoethanol amine, DMSO, or the like, and a washing process with a concentrated sulfuric acid, ammonia water, hydrogen peroxide water, or the like.

The laser treatment includes, but are not limited to, annealing, via processing, circuit formation treatment with direct pattern writing, and a pretreatment for separation from the support.

In addition, in the laminate formed using the double-sided adhesive of the present invention, a dicing tape may be attached to the treated surface (preferably the ground surface) of the wafer after the treatment. By attaching the dicing tape in advance, dicing can be quickly performed after the support and the double-sided adhesive are peeled off.

In the semiconductor production process, after the above treatment, the support is separated from the double-sided adhesive, but the treatment before peeling may be performed in advance. Specifically, it is possible to appropriately adopt a method such as laser treatment and swelling and dissolution of the double-sided adhesive by a solvent before mechanical peeling, but it is preferable not to perform these treatments from the viewpoint of cost effectiveness due to the simplified apparatus.

### 10° Peel Strength

In the evaluation of the adhesive force of the double-sided adhesive of the present invention, the 10° peel strength P₁ between the silicon back surface-grinding support substrate made of borosilicate glass and the adhesive surface A in a case where the silicon back surface-grinding support substrate made of borosilicate glass is used as the support is measured. In addition, the 10° peel strength P₂ between the Si mirror wafer and the adhesive surface B in a case where the Si mirror wafer is used as the wafer is measured.

The 10° peel strength P₁ between the silicon back surface-grinding support substrate made of the borosilicate glass and the adhesive surface A and the 10° peel strength P₂ between the Si mirror wafer and the adhesive surface B are a force (N/mm) per the width of a peeling portion required to advance peeling while keeping the angle between the peeled layers (the support and the double-sided adhesive or the double-sided adhesive and the wafer) at 10°.

That is, the 10° peel strength P₁ between the silicon back surface-grinding support substrate made of borosilicate glass and the adhesive surface A and the 10° peel strength P₂ between the Si mirror wafer and the adhesive surface B can be determined by, in the state illustrated in FIG. 3 or in a state similar thereto, performing peeling between the silicon back surface-grinding support substrate 11 made of borosilicate glass and the double-sided adhesive 12 or between the double-sided adhesive 12 and Si mirror wafer 13, measuring the force required for peeling, and dividing the force by the width of the peeling portion. More specifically, the 10° peel strength P₁ and the 10° peel strength P₂ can be measured by the following method.

Since the support and the wafer are usually rigid or also usually brittle, it is usually difficult to keep the angle between the peeled layers at 10° as the laminate in which the support, the double-sided adhesive, and the wafer laminated. Therefore, when the 10° peel strength P₁ between the silicon back surface-grinding support substrate made of borosilicate glass and the adhesive surface A is measured, a sample for measuring the 10° peel strength P₁ without having a wafer is used (FIGS. 3(a) and 3(c)), and when the 10° peel strength P₂ between the Si mirror wafer and the adhesive surface B is measured, a sample for measuring the 10° peel strength P₂ without having a support is used (FIGS. 3(b) and 3(d)).

In the former case, when the double-sided adhesive has the base film, the sample for measuring the 10° peel strength P₁ is composed of the silicon back surface-grinding support substrate made of borosilicate glass and the double-sided adhesive having the base film and measurement is performed (FIG. 3(a)). When the double-sided adhesive does not have the base film and is only the adhesive layer, a polyimide film or the like is lined on the adhesive layer to configure the sample for measuring the 10° peel strength P₁ and measurement is performed (FIG. 3(c)).

In the latter case, when the double-sided adhesive has the base film, the sample for measuring the 10° peel strength P₂ is composed of the double-sided adhesive having the base film and the Si mirror wafer and measurement is performed (FIG. 3(b)). When the double-sided adhesive does not have the base film and is only the adhesive layer, a polyimide film or the like is lined on the adhesive layer to configure the sample for measuring the 10° peel strength P₂ and measurement is performed (FIG. 3(d)).

The peel strength ratio P₂/P₁ is preferably 1.1 or more, and particularly preferably 1.3 or more.

There is no particular upper limit to the peel strength ratio P₂/P₁, but it is desirable that the peel strength P₂ between the Si mirror wafer and the adhesive surface B is not excessive from the viewpoint of appropriately peeling the wafer from the double-sided adhesive. In addition, from the viewpoint of stably performing the wafer treatment, particularly machine processing, it is desirable that the 10° peel strength P₁ between the silicon back surface-grinding support substrate made of borosilicate glass and the adhesive surface A is not excessively small. Therefore, the peel strength ratio P₂/P₁ is preferably 30 or less, more preferably 15 or less, and particularly preferably 7 or less.

The 10° peel strength P₁ between the silicon back surface-grinding support substrate made of borosilicate glass and the adhesive surface A is preferably 12 N/25 mm or less. The 10° peel strength P₁ between the silicon back surface-grinding support substrate made of borosilicate glass and the adhesive surface A is more preferably 10 N/25 mm or less, and particularly preferably 7 N/25 mm or less.

The 10° peel strength P₁ between the silicon back surface-grinding support substrate made of borosilicate glass and the adhesive surface A is preferably 0.5 N/25 mm or more, and more preferably 1 N/25 mm or more.

Since the 10° peel strength P₁ between the silicon back surface-grinding support substrate made of borosilicate glass and the adhesive surface A is 12 N/25 mm or less, the support can be stably peeled off from the double-sided adhesive over the entire surface of the laminate without applying an excessive stress to the wafer by a relatively simple process such as mechanical peeling. When the 10° peel strength P₁ between the silicon back surface-grinding support substrate made of borosilicate glass and the adhesive surface A is 0.5 N/25 mm or more, the wafer treatment, particularly the machine processing, can be stably performed.

The 10° peel strength P₂ between the Si mirror wafer and the adhesive surface B is preferably 35 N/25 mm or less, and more preferably 30 N/25 mm or less.

The 10° peel strength P₂ between the Si mirror wafer and the adhesive surface B is preferably 2 N/25 mm or more, and more preferably 3 N/25 mm or more.

Since the 10° peel strength P₂ between the Si mirror wafer and the adhesive surface B is 35 N/25 mm or less, the separation of the double-sided adhesive and the wafer can be attained by separating the support from the laminate and then removing the double-sided adhesive remaining on the wafer. When the 10° peel strength P₂ between the Si mirror wafer and the adhesive surface B is 2 N/25 mm or more, the wafer treatment, particularly the machine processing, can be stably performed.

By using the double-sided adhesive of the present invention, the wafer after the wafer treatment can be easily separated from the laminate.

The separation of the wafer from the laminate is preferably attained by separating the support from the laminate and then removing the double-sided adhesive remaining on the wafer. In this embodiment, when the double-sided adhesive remaining on the wafer is removed, since usually the rigid support is already separated from the laminate, the wafer can be separated from the double-sided adhesive without applying an excessive stress to the wafer, and a risk of damaging the functional layer or the like formed on the wafer can be limited.

A method for separating the support from the double-sided adhesive is not particularly limited, but it is preferable to use mechanical peeling.

Both the separation between the support and the adhesive surface A and the separation between the wafer and the adhesive surface B may be performed by mechanical peeling, or a method other than the mechanical peeling may be adopted to one of them.

In the double-sided adhesive of the present invention, when the peel strength ratio P₂/P₁ is 1.1 or more, peeling between the silicon back surface-grinding support substrate made of borosilicate glass and the adhesive surface A is relatively easily performed. Therefore, the support can be stably peeled off from the laminate over the entire surface of the laminate by a relatively simple process such as mechanical peeling. In this case, since peeling at an unintended interface, that is, at the interface between the wafer and the double-sided adhesive is effectively suppressed, the risk of damaging the functional layer or the like formed on the wafer is limited.

In the laminate composed of the silicon back surface-grinding support substrate made of borosilicate glass, the adhesive, and the Si mirror wafer, which are separated in the measurement of the 10° peel strength, the ratio P₂/P₁ of the 10° peel strength P₂ between the Si mirror wafer and the adhesive surface B to the 10° peel strength P₁ between the silicon back surface-grinding support substrate made of borosilicate glass and the adhesive surface A, which is measured while keeping the angle between the peeled layers at 10° respectively, is 1.1 or more. The 10° peel strength P₁ between the silicon back surface-grinding support substrate made of borosilicate glass and the adhesive surface A and the 10° peel strength P₂ between the Si mirror wafer and the adhesive surface B are a measured value after a history equivalent to the wafer treatment. For example, when a thermal history of 150 to 200°C is added in the wafer treatment, the 10° peel strength is a value after the thermal history is added. Such a thermal history can be appropriately performed at a temperature and time in a range usually used in the wafer treatment of the semiconductor production process.

In the double-sided adhesive of the present invention, when the peel strength ratio P₂/P₁ is 1.1 or more, the support can be stably peeled off from the adhesive over the entire surface of the laminate by a relatively simple process such as mechanical peeling.

In this case, since peeling at an unintended interface, that is, at the interface between the wafer and the double-sided adhesive is effectively suppressed, the risk of damaging the functional layer or the like formed on the wafer is limited.

In addition, since a phenomenon in which a part of the adhesive remains on the support or a part of the adhesive on the wafer is lost is also effectively suppressed, a risk that the wafer or the support are damaged due to the application of an ununiform stress is also limited.

Means for adjusting the 10° peel strength P₁, the 10° peel strength P₂, and the peel strength ratio P₂/P₁ is not particularly limited, but, for example, they can be appropriately increased or decreased by means conventionally used in the technical field. More specifically, they can be appropriately increased or decreased by the composition and the production process of each layer, the production process of the laminate, and the like, and for example, the 10° peel strength P₁ and the 10° peel strength P₂ can be increased by increasing the amount of adhesive component such as an adhesive agent or a pressure-sensitive adhesive agent used for the double-sided adhesive, and the 10° peel strength P₁ and the 10° peel strength P₂ can be decreased by adding a release agent to the double-sided adhesive.

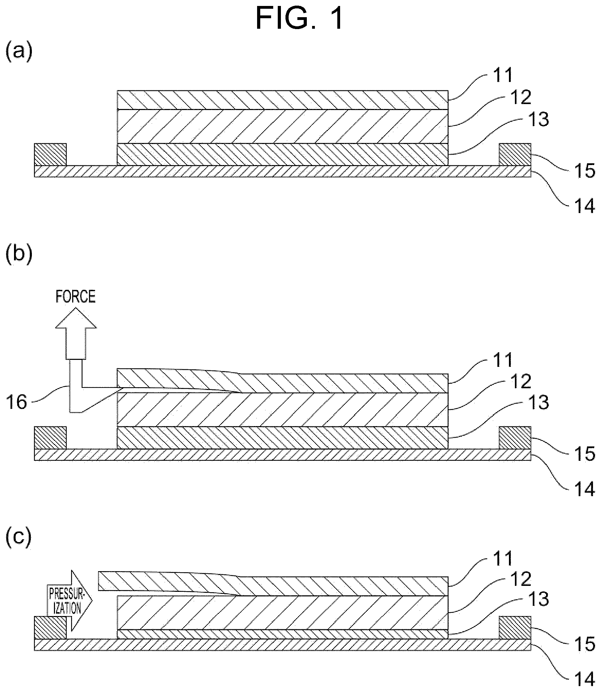

A method for mechanically peeling off the support and/or the wafer from the laminate formed using the double-sided adhesive of the present invention is also not particularly limited, and peeling can be performed using a commercially available apparatus or the like as appropriate. For example, it is preferable to perform the peeling by the method illustrated in FIG. 1.

In this method, the wafer 13 side of the laminate is fixed onto a chuck table (not illustrated) via a dicing tape 14, and then the support 11 is held by a holding mechanism (not illustrated).

A remover 16 is slid into the interface between the support 11 and the double-sided adhesive 12, an upward force is applied to the end of the support 11, and a peeling interface that triggers peeling is formed between the support 11 and the double-sided adhesive 12 (FIG. 1(b)).

While the support 11 is warped due to the application of a pressure by the holding mechanism, the peeling interface is expanded to advance the peeling (FIG. 1(c)).

When the peeling interface is expanded and the peeling interface is formed on the entire surface between the support 11 and the double-sided adhesive 12, the support 11 is peeled off from the double-sided adhesive 12.

The commercially available apparatus as described above include XBC Gen2 manufactured by SUSS MicroTec SE., EVG805 manufactured by EV Group (EVG), and TWH-SR series manufactured by TAZMO CO., LTD.

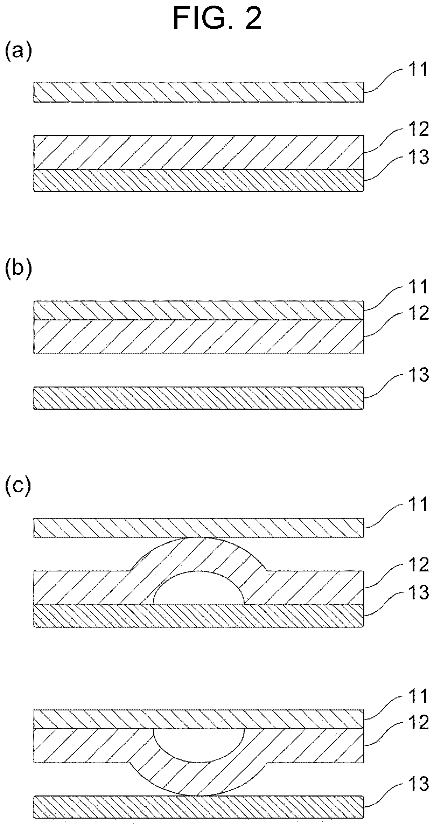

In this case, according to the present invention, since peeling at the interface between the double-sided adhesive 12 and the wafer 13, which is not intended to be performed at this stage, is effectively suppressed, the functional layer or the like formed on the wafer 13 is effectively protected by the double-sided adhesive 12, and the risk that such a functional layer or the like is damaged can be limited (FIG. 2(a)).

In the conventional technology, before peeling between the support 11 and the double-sided adhesive 12, peeling may occur at the interface between the double-sided adhesive 12 and the wafer 13, which is not intended at this stage (FIG. 2(b)). As a result, the electronic circuit or the like formed on the wafer 13 may be damaged during peeling, or may be damaged in the subsequent process that still requires protection with the double-sided adhesive 12.

In addition, in the conventional technology, there is a case where the support is not capable of being completely peeled off because a part of the double-sided adhesive 12 remains on the support 11 or the double-sided adhesive 12 on the wafer 13 is partially lost (FIG. 2(c)). As a result, the wafer 13 and the support 11 may be damaged due to the application of an ununiform stress. When a part of the double-sided adhesive remains on the wafer, it may be necessary to dissolve the double-sided adhesive with a solvent in order to remove the double-sided adhesive.

According to the double-sided adhesive of the present invention, it is possible to solve such problems of the conventional technology, to prevent peeling at an unintended interface and uneven peeling, or to significantly reduce at least the occurrence frequency of the peeling described above, and to provide the wafer to many and/or a wide variety of treatments without damaging the functional layer formed on the wafer.

The wafer treated with the double-sided adhesive of the present invention can be further provided to the subsequent steps to produce a final product. In a case where the functional layer is formed on the wafer, steps such as dicing, bonding, packaging, and sealing, which are usually used for producing an electronic device such as a semiconductor device, can be performed to produce the final product.

### [Examples]

Hereinafter, the present invention will be specifically described. It is note that the present invention is not limited by the following Examples in any sense.

The physical properties and characteristics in Examples and Comparative Examples were evaluated by the following methods.

### (1) Mechanical Peelability from Support

After applying a predetermined thermal history shown in Table 1 to the prepared laminate, the laminate was fixed on the dicing tape 14 attached to a ring frame 15 at room temperature with the Si mirror wafer 13 side facing down, and the dicing tape 14 was fixed by vacuum chucking (FIG. 1(a)). In order to perform peeling at the interface between the silicon back surface-grinding support substrate 11 made of borosilicate glass and the double-sided adhesive 12, as illustrated in FIG. 1, the remover 16 was slid into the interface between the support 11 and the double-sided adhesive 12, and an upward force of typically approximately 120 N was applied to the end of the silicon back surface-grinding support substrate 11 made of borosilicate glass to form the peeling interface that triggers the peeling between the silicon back surface-grinding support substrate 11 made of borosilicate glass and the double-sided adhesive 12 (FIG. 1(b)).

Subsequently, a pressure was applied to the formed peeling interface to expand the peeling interface, thereby peeling the silicon back surface-grinding support substrate 11 made of borosilicate glass (FIG. 1(c)). The peelability was evaluated in accordance with the following criteria.
∘: It was possible to peel off the entire surface of an intended interface between the silicon back surface-grinding support substrate made of borosilicate glass and the double-sided adhesive, and no damage occurred in the wafer.
×: Peeling occurred at an unintended interface between the double-sided adhesive and the wafer.

### (2) Removability of Double-Sided Adhesive from Wafer

For the laminate of the Si mirror wafer 13 and the double-sided adhesive 12 fixed to the dicing tape 14 attached to the ring frame 15 after the mechanical peelability evaluation described above, a pressure-sensitive adhesive tape 17 was attached to the entire surface of the double-sided adhesive 12. The dicing tape 14 was fixed with a vacuum chuck, and the double-sided adhesive 12 was peeled off at a peel angle of 90° and a peel rate of 5 mm/s. The peelability was evaluated in accordance with the following criteria.
∘: The double-sided adhesive was completely peeled off from the Si mirror wafer, and no damage occurred in the Si mirror wafer.
×: It was not possible to peel off the double-sided adhesive from the Si mirror wafer.

### (3) 10° Peel Strength P₁ (10° Peel Strength between Silicon Back Surface-Grinding Support Substrate Made of Borosilicate Glass and Adhesive Surface A)

### (3-1) Case of Using Base Film in Double-Sided Adhesive

The sample for measuring P₁ was prepared by laminating the adhesive layer A1 20 on the base film 19.

### (3-2) Case of Not Using Base Film in Double-Sided Adhesive

A polyimide film 21 (a double-sided plasma treatment, a thickness of 38 µm, manufactured by DU PONT-TORAY CO., LTD., product name: Kapton (Registered Trademark) 150EN-A) was prepared, and the sample for measuring P₁ in which the same material as that of the double-sided adhesive 12 was laminated on the polyimide film was prepared.

### (3-3) Measurement

The sample for measuring P₁ prepared in (3-1) or (3-2) described above was cut into 2.5 cm × 5 cm, and the surface of the sample for measuring P₁ on the same material side as the adhesive layer A1 20 or the double-sided adhesive 12 was attached to the attachment surface side of the support 11 cut into 3 cm × 6 cm with one reciprocation by a 2 kg roller. Next, the prepared laminate of the silicon back surface-grinding support substrate made of borosilicate glass and the sample for measuring P₁ was heated at 140°C for 30 minutes as a condition assuming a pretreatment in a laminate forming step in each of Examples and Comparative Examples. Furthermore, as a condition assuming an actual wafer treatment step, a predetermined thermal history shown in Table 1 was added, and then the measurement sample was left to stand at 22.5±1°C and relative humidity of 50±10% for 1 week to be cooled, and then in such temperature and humidity conditions, the 10° peel strength P₁ was measured at a tensile rate of 300 mm/min and a peel angle of 10° using VPA-S (manufactured by Kyowa Interface Science Co., Ltd.) (FIG. 3(a) or 3(c)).

### (4) 10° Peel Strength P₂ (10° Peel Strength between Si Mirror Wafer and Adhesive Surface B)

### (4-1) Case of Using Base Film in Double-Sided Adhesive

The sample for measuring P₂ was prepared by laminating the adhesive layer B1 18 on the base film 19.

### (4-2) Case of Not Using Base Film in Double-Sided Adhesive

The polyimide film 21 (a double-sided plasma treatment, a thickness of 38 µm, manufactured by DU PONT-TORAY CO., LTD., product name: Kapton (Registered Trademark) 150EN-A) was prepared, and the sample for measuring P₂ in which the same material as that of the double-sided adhesive 12 was laminated on the polyimide film was prepared.

### (4-3) Measurement

The sample for measuring P₂ prepared in (4-1) or (4-2) described above was cut into 2.5 cm × 5 cm, and the surface of the sample for measuring P₂ on the same material side as the adhesive layer B1 18 or the double-sided adhesive 12 was attached to the attachment surface side of the Si mirror wafer cut into 3 cm × 6 cm with one reciprocation by a 2 kg roller. Next, the prepared laminate of the Si mirror wafer and the sample for measuring P₂ was heated at 140°C for 30 minutes as a condition assuming the pretreatment in the laminate forming step in each of Examples and Comparative Examples. Furthermore, as a condition assuming the actual wafer treatment step, the predetermined thermal history shown in Table 1 was added, and then the measurement sample was left to stand at 22.5±1°C and relative humidity of 50±10% for 1 week to be cooled, and then in such temperature and humidity conditions, the 10° peel strength P₂ was measured at a tensile rate of 300 mm/min and a peel angle of 10 degrees using VPA-S (manufactured by Kyowa Interface Science Co., Ltd.) (FIG. 3(b) or 3(d)).

The details of the materials used in Examples and Comparative Examples are as follows.

### Support and Wafer

The following glass, Si, or wafer with a PBO film was used as either the support or the wafer.

### · Glass

A silicon back surface-grinding support substrate made of borosilicate heat-resistant glass having outer diameter of 300 or 200 mm × thickness of 700 µm was used.

### · Si

A Si mirror wafer having outer diameter of 300 or 200 mm × thickness of 750 µm was used.

### · Wafer with PBO Film

A wafer in which a PBO film of 6 µm was provided on a Si mirror wafer having outer diameter of 300 or 200 mm × thickness of 730 µm was used.

### Resin for Forming Double-Sided Adhesive

### · (Meth)Acrylic Resin Solution N

49 parts by mass of ethyl acrylate, 20 parts by mass of 2-ethyl hexyl acrylate, 21 parts by mass of methyl acrylate, 10 parts by mass of glycidyl methacrylate, and 0.5 parts by mass of a benzoyl peroxide-based polymerization initiator as a polymerization initiator were reacted in a solvent consisting of 65 parts by mass of toluene and 50 parts by mass of ethyl acetate at 80°C for 10 hours. After the completion of the reaction, the obtained solution was cooled, 25 parts by mass of xylene, 5 parts by mass of an acrylic acid, and 0.5 parts by mass of tetradecyl dimethyl benzyl ammonium chloride were added to the cooled solution, and a reaction was caused at 85°C for 32 hours while blowing the air to obtain a (meth)acrylic resin solution N.

### · Silicone-Modified (Meth)Acrylic Resin Solution NS

0.3 parts by mass of carboxy-modified organopolysiloxane (manufactured by Shin-Etsu Chemical Co., Ltd., product name: X-22-3710) was added to 270 parts by mass of the (meth)acrylic resin solution N described above, and a reaction was caused at 60°C for 7 days to obtain a silicone-modified (meth)acrylic resin solution NS.

### · (Meth)Acrylic Resin Solution L

A (meth)acrylic pressure-sensitive adhesive (Bind Serum SA591 manufactured by Mitsui Chemicals, Inc.) was used.

### · (Meth)Acrylic Resin Emulsion H

By using 0.5 parts by mass of ammonium persulfate as a polymerization initiator, 63 parts by mass of 2-ethyl hexyl acrylate, 21 parts by mass of n-butyl acrylate, 9 parts by mass of methyl methacrylate, 3 parts by mass of 2-hydroxyethyl methacrylate, 2 parts by mass of a methacrylic acid, 1 part by mass of acrylamide, 1 part by mass of polytetramethylene glycol diacrylate (manufactured by NOF CORPORATION, product name: ADT-250), and 2 parts by mass of an aqueous solution of ammonium polyoxyethylene nonyl propenyl phenyl ether sulfate (manufactured by DKS Co., Ltd., product name: Aqualon HS-1025) were subjected to emulsion polymerization at 70°C in deionized water. After the completion of the polymerization, pH was adjusted to 7.0 using ammonia water to obtain a (meth)acrylic resin emulsion H having a solid content of 56.5% by mass.

### · (Meth)Acrylic Resin Emulsion B

By using 0.5 parts by mass of a 4,4'-azobis-4-cyanovaleric acid (manufactured by Otsuka Chemical Co., Ltd., product name: ACVA) as a polymerization initiator, 74 parts by mass of n-butyl acrylate, 14 parts by mass of methyl methacrylate, 9 parts by mass of 2-hydroxyethyl methacrylate, 2 parts by mass of a methacrylic acid, 1 part by mass of acrylamide, and 3 parts by mass of HS-1025 were subjected to emulsion polymerization at 70°C in deionized water. After the completion of the polymerization, pH was adjusted to 7.0 using ammonia water to obtain a (meth)acrylic resin emulsion B having a solid content of 42.5% by mass.

### · (Meth)Acrylic Resin Emulsion A

By using 0.65 parts by mass of ACVA as a polymerization initiator, 63 parts by mass of 2-ethyl hexyl acrylate, 18 parts by mass of n-butyl acrylate, 12 parts by mass of methyl methacrylate, 3 parts by mass of 2-hydroxyethyl methacrylate, 2 parts by mass of a methacrylic acid, 1 part by mass of acrylamide, 1 part by mass of ADT-250, and 2 parts by mass of Aqualon HS-1025 were subjected to emulsion polymerization at 70°C in deionized water. After the completion of the polymerization, pH was adjusted to 7.0 using ammonia water to obtain a (meth)acrylic resin emulsion A having a solid content of 42.5% by mass.

### · (Meth)Acrylic Resin Emulsion S

By using 0.5 parts by mass of ACVA as a polymerization initiator, 47 parts by mass of n-butyl acrylate, 22 parts by mass of methyl methacrylate, 9 parts by mass of 2-hydroxyethyl methacrylate, 15 parts by mass of a methacrylic acid, 8 parts by mass of acrylamide, and 0.2 parts by mass of Aqualon HS-1025 were subjected to emulsion polymerization at 70°C in deionized water to obtain a (meth)acrylic resin emulsion S having a solid content of 40% by mass.

### Base Film

### · PEN Film

A polyethylene naphthalate film (a double-sided corona treatment, thickness: 50 µm, manufactured by Toyobo Film Solutions Limited, Teonex Q83) was used.

### · PET Film

A biaxially stretched polyethylene terephthalate film (a double-sided corona treatment, a thickness of 38 µm, manufactured by Toray Industries, Inc., Lumirror S10) was used.

### · Polyimide Film

A polyimide film (a double-sided plasma treatment, a thickness of 38 µm, manufactured by DU PONT-TORAY CO., LTD., product name: Kapton (Registered Trademark) 150EN-A) was used.

### (Example 1)

2.84 parts by mass of HDI isocyanurate (manufactured by Tosoh Corporation, product name: CORONATE HX), 50 parts by mass of dipentaerythritol penta/hexaacrylate (manufactured by TOAGOSEI CO., LTD., product name: ARONIX M-402), 2.0 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 250 parts by mass of the (meth)acrylic resin solution L to obtain a coating liquid 1-1 for an adhesive layer on a support side. The coating liquid 1-1 was applied to the base film (the PET film) and dried at 100°C for 10 minutes to form an adhesive layer 1-1 having a thickness of 25 µm as the adhesive layer on the support side. Next, a polyethylene terephthalate film (a separator) subjected to a silicone release treatment was bonded to obtain a laminate consisting of the adhesive layer 1-1 and the base film with the separator.

Next, 100 parts by mass of the (meth)acrylic resin emulsion A, 0.7 parts by mass of the (meth)acrylic resin emulsion S, 0.3 parts by mass of dimethyl ethanol amine, 5 parts by mass of an epoxy-based compound (manufactured by Nagase ChemteX Corporation, product name: Ex-614), 9 parts by weight of butyl carbinol, and 12 parts by weight of pure water were respectively mixed to prepare a coating liquid 1-2 for the adhesive layer on the wafer side. The coating liquid 1-2 was applied to a polyethylene terephthalate film (a separator) subjected to a silicone release treatment, and dried at 120°C for 3 minutes to form an adhesive layer 1-2 having a thickness of 20 µm as the adhesive layer on the wafer side.

Subsequently, the adhesive layer 1-2 was bonded to the base film side of a laminate consisting of the adhesive layer 1-1 and the base film described above to prepare a double-sided adhesive precursor before a heat treatment, composed of three layers of the adhesive layer 1-1, the base film, and the adhesive layer 1-2 with the separator. The separatosr used on both sides of the three-layer configuration were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 1-1 and the base film and a laminate consisting of the base film and the adhesive layer 1-2 were individually prepared (the application conditions were the same), and the 10° peel strengths P₁ and P₂ were measured by the method described above. Measurement results are shown in Table 1.

### (Example 1-1)

A laminate consisting of the support, the double-sided adhesive, and the wafer in this order was prepared as with Example 1, except that Si (the support) and the wafer with a PBO film (the wafer) were used. The results of evaluating the mechanical peelability and the removability of the laminate are shown in Table 1.

### (Example 2)

2.84 parts by mass of HDI isocyanurate (manufactured by Tosoh Corporation, product name: CORONATE HX), 50 parts by mass of dipentaerythritol penta/hexaacrylate (manufactured by TOAGOSEI CO., LTD., product name: ARONIX M-402), 2.0 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 2-1 for an adhesive layer on a support side. The coating liquid 2-1 was applied to the base film (the PEN film) and dried at 100°C for 10 minutes to form an adhesive layer 2-1 having a thickness of 25 µm as the adhesive layer on the support side. Next, a polyethylene terephthalate film (a separator) subjected to a silicone release treatment was bonded to obtain a laminate consisting of the adhesive layer 2-1 and the base film with the separator.

0.1 parts by mass of HDI isocyanurate (manufactured by Tosoh Corporation, product name: CORONATE HX), 30 parts by mass of dipentaerythritol penta/hexaacrylate (manufactured by TOAGOSEI CO., LTD., product name: ARONIX M-402), 0.5 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 2-2 for the adhesive layer on the wafer side. The coating liquid 2-2 was applied to a polyethylene terephthalate film (a separator) subjected to a silicone release treatment and dried at 100°C for 10 minutes to form an adhesive layer 2-2 having a thickness of 40 µm as the adhesive layer on the wafer side. Next, the adhesive layer 2-2 was bonded to the base side of a laminate consisting of the adhesive layer 2-1 and the base film to obtain a laminate composed of three layers of the adhesive layer 2-1, the base film, and the adhesive layer 2-2 with the separator.

5.68 parts by mass of HDI isocyanurate (manufactured by Tosoh Corporation, product name: CORONATE HX), 30 parts by mass of dipentaerythritol penta/hexaacrylate (manufactured by TOAGOSEI CO., LTD., product name: ARONIX M-402), 0.5 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION) were added to 270 parts by mass of the (meth)acrylic resin solution N to obtain a coating liquid 2-3 for the adhesive layer on the wafer side. The coating liquid 2-3 was applied to a polyethylene terephthalate film (a separator) subjected to a silicone release treatment and dried at 100°C for 10 minutes to form an adhesive layer 2-3 having a thickness of 10 µm as the adhesive layer on the wafer side. Subsequently, the adhesive layer 2-3 was bonded to the adhesive layer 2-2 side of a laminate composed of the three layers of the adhesive layer 2-1, the base film, and the adhesive layer 2-2 with the separator described above to prepare a double-sided adhesive precursor before a heat treatment, composed of four layers of the adhesive layer 2-1, the base film, the adhesive layer 2-2, and the adhesive layer 2-3 with the separator. The separators used on both sides of the four-layer structure were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 2-1 and the base film and a laminate consisting of the base film, the adhesive layer 2-2, and the adhesive layer 2-3 were individually prepared (the application conditions were the same), and the 10° peel strengths P₁ and P₂ were measured by the method described above. Measurement results are shown in Table 1.

### (Example 2-1)

A laminate consisting of the support, the double-sided adhesive, and the wafer in this order was prepared as with Example 2, except that Si (the support) and the wafer with a PBO film (the wafer) were used. The results of evaluating the mechanical peelability and the removability of the laminate are shown in Table 1.

### (Example 3)

2.84 parts by mass of HDI isocyanurate (manufactured by Tosoh Corporation, product name: CORONATE HX), 50 parts by mass of dipentaerythritol penta/hexaacrylate (manufactured by TOAGOSEI CO., LTD., product name: ARONIX M-402), 2.0 parts by mass of an acryl group-containing polyether-modified polydimethyl siloxane (manufactured by Big Chemie Japan Co., Ltd., product name: BYK-UV3500), and 2 parts by mass of Perkadox 12XL25 (manufactured by KAYAKU NOURYON CORPORATION) were added to 270 parts by mass of the (meth)acrylic resin solution N to obtain a coating solution 3-1 for an adhesive layer on a support side. The coating liquid 3-1 was applied to the base film (the PEN film) and dried at 100°C for 10 minutes to form an adhesive layer 3-1 having a thickness of 25 µm as the adhesive layer on the support side. Next, a polyethylene terephthalate film (a separator) subjected to a silicone release treatment was bonded to obtain a laminate consisting of the adhesive layer 3-1 and the base film with the separator.

0.1 parts by mass of HDI isocyanurate (manufactured by Tosoh Corporation, product name: CORONATE HX), 30 parts by mass of dipentaerythritol penta/hexaacrylate (manufactured by TOAGOSEI CO., LTD., product name: ARONIX M-402), and 2 parts by mass of Perkadox 12XL25 (manufactured by KAYAKU NOURYON CORPORATION) were added to 270 parts by mass of the (meth)acrylic resin solution N to obtain a coating liquid 3-2 for the adhesive layer on the wafer side. The coating liquid 3-2 was applied to a polyethylene terephthalate film (a separator) subjected to a silicone release treatment and dried at 100°C for 10 minutes to form an adhesive layer 3-2 having a thickness of 40 µm as the adhesive layer on the wafer side. Next, the adhesive layer 3-2 was bonded to the base side of a laminate consisting of the adhesive layer 3-1 and the base film to obtain a laminate having a three-layer structure of the adhesive layer 3-1, the base film, and the adhesive layer 3-2 with the separator.

5.68 parts by mass of HDI isocyanurate (manufactured by Tosoh Corporation, product name: CORONATE HX), 30 parts by mass of dipentaerythritol penta/hexaacrylate (manufactured by TOAGOSEI CO., LTD., product name: ARONIX M-402), and 2 parts by mass of Perkadox 12XL25 (manufactured by KAYAKU NOURYON CORPORATION) were added to 270 parts by mass of the (meth)acrylic resin solution N to obtain a coating liquid 3-3 for the adhesive layer on the wafer side. The coating liquid 3-3 was applied to a polyethylene terephthalate film (a separator) subjected to a silicone release treatment and dried at 100°C for 10 minutes to form an adhesive layer 3-3 having a thickness of 10 µm as the adhesive layer on the wafer side. Subsequently, the adhesive layer 3-3 was bonded to the adhesive layer 3-2 side of a laminate having a three-layer structure of the adhesive layer 3-1, the base film, and the adhesive layer 3-2 with the separator to prepare a double-sided adhesive precursor before a heat treatment having a four-layer structure of the adhesive layer 3-1, the base film, the adhesive layer 3-2, and the adhesive layer 3-3 with the separator. The separators used on both sides of the four-layer structure were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 3-1 and the base film and a laminate consisting of the base film, the adhesive layer 3-2, and the adhesive layer 3-3 were individually prepared (the application conditions were the same), and the 10° peel strengths P₁ and P₂ were measured by the method described above. Measurement results are shown in Table 1.

### (Example 4)

The coating liquid 1-1 for the adhesive layer on the support side in Example 1 was applied to a polyethylene terephthalate film (a separator) subjected to a silicone release treatment and dried at 100°C for 10 minutes to form an adhesive layer 4-1 having a thickness of 25 µm as the adhesive layer on the support side. Then, the base film (the polyimide film) was bonded to obtain a laminate consisting of the adhesive layer 4-1 and the base film with the separator.

42.6 parts by mass of the (meth)acrylic resin emulsion H, 57.4 parts by mass of the (meth)acrylic resin emulsion B, 0.4 parts by mass of dimethyl ethanol amine, 3.4 parts by mass of an epoxy-based compound (manufactured by Nagase ChemteX Corporation, product name: Ex-1610), 13 parts by weight of butyl carbinol, and 20 parts by weight of pure water were respectively mixed to prepare a coating liquid 4-2 for the adhesive layer on the wafer side. The coating liquid 4-2 was applied to a polyethylene terephthalate film (a separator) subjected to a silicone release treatment and dried at 120°C for 3 minutes to form an adhesive layer 4-2 having a thickness of 13 µm as the adhesive layer on the wafer side. Subsequently, the adhesive layer 4-2 was bonded to the base side of a laminate of the adhesive layer 4-1 and the base film described above to prepare a double-sided adhesive precursor before a heat treatment having a three-layer structure of the adhesive layer 4-1, the base film, and the adhesive layer 4-2 with the separator. The separators used on both sides of the three-layer configuration were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 4-1 and the base film and a laminate consisting of the base film and the adhesive layer 4-2 were individually prepared (the application conditions were the same), and the 10° peel strengths P₁ and P₂ were measured by the method described above. Measurement results are shown in Table 1.

### (Example 4-1)

A laminate consisting of the support, the double-sided adhesive, and the wafer in this order was prepared as with Example 4, except that Si (the support) and glass (the wafer) were used. The results of evaluating the mechanical peelability and the removability of the laminate are shown in Table 1.

### (Example 5)

The coating liquid 1-1 for the adhesive layer on the support side in Example 1 was applied to a polyethylene terephthalate film (a separator) subjected to a silicone release treatment and dried at 100°C for 10 minutes to form an adhesive layer 5-1 having a thickness of 25 µm as the adhesive layer on the support side. Next, the base film (the PEN film) was bonded to obtain a laminate consisting of the adhesive layer 5-1 and the base film with the separator.

The coating liquid 4-2 for the adhesive layer on the wafer side in Example 4 was applied to a polyethylene terephthalate film (a separator) subjected to a silicone release treatment and dried at 100°C for 10 minutes to form an adhesive layer 5-2 having a thickness of 13 µm as the adhesive layer on the wafer side. Subsequently, the adhesive layer 5-2 was bonded to the base side of a laminate consisting of the adhesive layer 5-1 and the base film to prepare a double-sided adhesive precursor before a heat treatment having a three-layer structure of the adhesive layer 5-1, the base film, and the adhesive layer 5-2 with the separator. The separators used on both sides of the three-layer configuration were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 5-1 and the base film and a laminate consisting of the base film and the adhesive layer 5-2 were individually prepared (the application conditions were the same), and the 10° peel strengths P₁ and P₂ were measured by the method described above. Measurement results are shown in Table 1.

### (Example 5-1)

A laminate consisting of the support, the double-sided adhesive, and the wafer in this order was prepared as with Example 4, except that Si (the support) and glass (the wafer) were used. The results of evaluating the mechanical peelability and the removability of the laminate are shown in Table 1.

### (Example 6)

0.5 parts by mass of HDI isocyanurate (manufactured by Tosoh Corporation, product name: CORONATE HX), 12 parts by mass of dipentaerythritol penta/hexaacrylate (manufactured by TOAGOSEI CO., LTD., product name: ARONIX M-400), 1.5 parts by mass of silicone diacrylate (manufactured by DAICEL-ALLNEX LTD., product name: Ebecryl 350), and 2 parts by mass of Perkadox 12XL25 (manufactured by KAYAKU NOURYON CORPORATION were) added to 270 parts by mass of the (meth)acrylic resin solution N to obtain a coating liquid 6-1 for the adhesive layer on the support side. The coating liquid 6-1 was applied to a polyethylene terephthalate film (a separator) subjected to a silicone release treatment and dried at 100°C for 10 minutes to form an adhesive layer 6-1 having a thickness of 100 µm as the adhesive layer on the support side. Then, the base film (the PET film) was bonded to obtain a laminate consisting of the adhesive layer 6-1 and the base film with the separator.

Next, the coating liquid 4-2 for the adhesive layer on the wafer side in Example 4 was applied to a polyethylene terephthalate film (a separator) subjected to a silicone release treatment and dried at 120°C for 3 minutes to form an adhesive layer 6-2 having a thickness of 6 µm as the adhesive layer on the wafer side. A laminate composed of the adhesive layer 6-1 and the base film was bonded to the base film side to prepare a double-sided adhesive precursor before a heat treatment having a three-layer structure of the adhesive layer 6-1, the base film, and the adhesive layer 6-2 with the separator.

The separators used on both sides of the three-layer configuration were peeled off, and glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

Separately, a laminate consisting of the adhesive layer 6-1 and the base film and a laminate consisting of the base film and the adhesive layer 6-2 were individually prepared (the application conditions were the same), and the 10° peel strengths P₁ and P₂ were measured by the method described above. Measurement results are shown in Table 1.

### (Example 7)

1.0 parts by mass of HDI isocyanurate (manufactured by Tosoh Corporation, product name: CORONATE HX) and 2 parts by mass of Perkadox 12XL25 (manufactured by KAYAKU NOURYON CORPORATION) were added to 269 parts by mass of the silicone-modified (meth)acrylic resin solution NS to obtain a pressure-sensitive adhesive coating liquid 7 for the double-sided adhesive. The coating liquid 7 was applied to a polyethylene terephthalate film (a separator) subjected to a silicone release treatment, and then dried at 100°C for 10 minutes to form an adhesive layer 7 having a thickness of 100 µm. Next, a polyethylene terephthalate film (a separator) subjected to a silicone release treatment was bonded to prepare a double-sided adhesive precursor before a heat treatment (with separators on both sides). The separators on both sides were peeled off, glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

The 10° peel strengths P₁ and P₂ were measured in accordance with the method described above (when the base film was not used in the double-sided adhesive agent). Measurement results are shown in Table 1.

### (Comparative Example 1)

0.1 parts by mass of HDI isocyanurate (manufactured by Tosoh Corporation, product name: CORONATE HX), 6 parts by weight of pentaerythritol tri/tetraacrylate (Manufactured by TOAGOSEI CO., LTD., product name: M-450), and 2 parts by mass of Perkadox 12XL25 (manufactured by KAYAKU NOURYON CORPORATION) were added to 269 parts by mass of the silicone-modified (meth)acrylic resin solution N to obtain a coating liquid C1 for the double-sided adhesive. This coating liquid was applied to a polyethylene terephthalate film (a separator) subjected to a silicone release treatment, and then dried at 100°C for 10 minutes to form an adhesive layer C1 having a thickness of 50 µm. Next, a polyethylene terephthalate film (a separator) subjected to a silicone release treatment was bonded to prepare a double-sided adhesive precursor before a heat treatment (with separators on both sides). The separators on both sides were peeled off, glass (the support) and Si (the wafer) were laminated with a vacuum laminator, and heated at 140°C for 30 minutes to prepare a laminate consisting of the support, the double-sided adhesive, and the wafer in this order. The results of evaluating the mechanical peelability and the removability of the laminate are shown in Table 1.

The 10° peel strengths P₁ and P₂ were measured in accordance with the method described above (when the base film was not used in the double-sided adhesive). Measurement results are shown in Table 1.

### [Table 1]

**Table 1**

| | Support | Configuration of double-sided adhesive | | | Wafer | Heating condition Assuming production process | Measurement of 10° peel strength | | | Evaluation | |
|---|---|---|---|---|---|---|---|---|---|---|---|
| | | Adhesive layer on side in contact with support | Base film | Adhesive layer on side in contact with wafer | | | P₁ [N/25mm] | P₂ [N/25mm] | P₂/P₁ | Mechanical peelability from support | Removability of double-sided adhesive from wafer |
| Example 1 | Glass | 25µm | PET 38µm | 20µm | Si | 154°C×30min | 3.9 | 32 | 8.2 | ○ | ○ |
| Example 1-1 | Si | | | | Wafer with PBO film | | | | | ○ | ○ |
| Example 2 | Glass | 25µm | PEN 50µm | 50µm | Si | 200°C×30min | 0.69 | 8.7 | 12.6 | ○ | ○ |
| Example 2-1 | Si | | | | Wafer with PBO film | | | | | ○ | ○ |
| Example 3 | Glass | 25µm | PEN 50µm | 50µm | Si | 200°C×30min | 0.97 | 10.4 | 10.7 | ○ | ○ |
| Example 4 | Glass | 25µm | Polyimide 38µm | 13µm | Si Glass | 200°C×30min | 9.3 | 26 | 2.8 | ○ | ○ |
| Example 4-1 | Si | | | | | | | | | ○ | ○ |
| Example 5 | Glass | 25µm | PEN 50µm | 13µm | Si | 200°C×30min | 9.8 | 26 | 2.7 | ○ | ○ |
| Example 5-1 | Si | | | | Glass | 200°C×30min | | | | ○ | ○ |
| Example 6 | Glass | 100µm | PET 38µm | 6µm | Si | 180°C×30min | 8.7 | 14.9 | 1.7 | ○ | ○ |
| Example 7 | Glass | 100µm Single layer | | | Si | 180°C×30min | 6.1 | 8 | 1.3 | ○ | ○ |
| Comparative Example 1 | Glass | 50µm Single layer | | | Si | 180°C×30min | 9.2 | 7.1 | 0.8 | × | ○ |

In the double-sided adhesive in which the ratio P₂/P₁ of the 10° peel strength P₂ between the Si mirror wafer and the adhesive surface B to the 10° peel strength P₁ between the silicon back surface-grinding support substrate made of borosilicate glass and the adhesive surface A was 1.1 or more, it was confirmed that the double-sided adhesive had excellent mechanical peelability and removability from the wafer even when a support other than the silicon back surface-grinding support substrate made of borosilicate glass or a wafer other than the Si mirror wafer was used.

### INDUSTRIAL APPLICABILITY

According to the double-sided adhesive of the present invention, a large number and/or a wide variety of steps can be performed on the wafer with high productivity and yield without damaging the electronic component such as a functional layer formed on the wafer, which greatly contributes to improvement in the productivity of the electronic device, and the double-sided adhesive has high applicability in various fields of industries such as an electronic component industry including a semiconductor process industry, an electrical/electronic industry using electronic components, a transport machine industry, an information communication industry, and a precision equipment industry.

### REFERENCE SIGNS LIST

- 11: Support or silicon back surface-grinding support substrate made from borosilicate glass
- 12: Double-sided adhesive
- 13: Wafer or Si mirror wafer
- 14: Dicing tape
- 15: Ring frame
- 16: Remover
- 17: Pressure-sensitive adhesive tape
- 18: Adhesive layer B 1
- 19: Base film
- 20: Adhesive layer A1
- 21: Polyimide film

## Claims

1. A double-sided adhesive for use in a wafer support system, comprising: one adhesive surface A; and another adhesive surface B,
wherein a ratio P₂/P₁ of 10° peel strength P₂ between a Si mirror wafer and the adhesive surface B to 10° peel strength P₁ between a silicon back surface-grinding support substrate made from borosilicate heat-resistant glass and the adhesive surface A, which is measured while keeping an angle between peeled layers at 10° respectively, is 1.1 or more.

2. The double-sided adhesive according to claim 1, wherein the 10° peel strength P₁ is 12 N/25 mm or less.

3. The double-sided adhesive according to claim 1 or 2, comprising: an adhesive layer A1 having the adhesive surface A; and an adhesive layer B1 having the adhesive surface B, wherein the adhesive layer A and the adhesive layer B1 have different compositions.

4. The double-sided adhesive according to any one of claims 1 to 3, wherein at least one of the adhesive layer A1 and the adhesive layer B1 contains a curable adhesive component.

5. The double-sided adhesive according to any one of claims 1 to 4, comprising a base film between the adhesive layer A1 and the adhesive layer B1.

6. The double-sided adhesive according to any one of claims 1 to 5, wherein at least one of the adhesive layer A1 and the adhesive layer B1 contains a release agent.
